# FASCICULE DE BREVET EUROPEEN

(11) **EP 2 501 212 B1**
(45) Date de publication et mention de la délivrance du brevet: **13.11.2013**
(21) Numéro de dépôt: 12159523.5
(22) Date de dépôt: 14.03.2012
(51) Int. Cl.: H05K 7/20

(54) **Dispositif de conversion d'energie, notamment pour une station sous marine de compression et de pompage, a moyens de refroidissement perfectionnes**
Vorrichtung zur Energieumwandlung mit perfektionierten Kühlmitteln, insbesondere für Unterwasser-Kompressions- und Pumpstation
Energy conversion device, in particular for an underwater compression and pumping station, with improved cooling means

(30) Priorité: 14.03.2011 FR 1152041
(43) Date de publication de la demande: 19.09.2012
(73) Titulaire: GE Energy Power Conversion Technology Limited, Rugby Warwickshire CV21 1BU (GB)
(72) Inventeur: Baerd, Henri, 77430 CHAMPAGNE SUR SEINE (FR); Godfroy, Guillaume, 78000 Versailles (FR)
(74) Mandataire: Serjeants LLP

(56) Documents cités:
- EP-A1- 1 310 759
- US-A1- 2010 139 544

## Description

La présente invention concerne un dispositif de conversion d'énergie, également appelé convertisseur, notamment pour un système d'entraînement électrique de station sous-marine de compression et de pompage.

Une telle station sous marine est destinée à l'exploitation de pétrole ou de gaz naturel, généralement en eaux profondes.

EP 1 310 759 décrit un exemple de dispositif de conversion d'énergie, comportant notamment un module de puissance et des moyens de refroidissement de ce module de puissance.

On connaît également déjà, dans l'état de la technique, un dispositif de conversion d'énergie, notamment pour un système d'entraînement électrique de stations sous marine de compression et de pompage. Un tel dispositif de conversion d'énergie comporte au moins un module de puissance, destiné à assurer la fonction de conversion d'énergie de manière connue en soi.

Le dispositif de conversion d'énergie comporte également des moyens de refroidissement du module de puissance, et une enceinte étanche de logement du module de puissance et d'au moins une partie des moyens de refroidissement.

Les moyens de refroidissement comprennent généralement un circuit de refroidissement dans lequel circule un fluide caloporteur, passant par un échangeur de chaleur avec le module de puissance. Les moyens de refroidissement comprennent également au moins une pompe d'entraînement du fluide caloporteur en circulation dans le circuit.

Il est possible de prévoir l'utilisation d'une huile diélectrique en tant que fluide caloporteur.

Lorsque le dispositif de conversion d'énergie est agencé sur un fond marin, la température de l'eau de mer environnant le dispositif est généralement comprise entre 0°C et 10°C. Ainsi, au repos, l'huile diélectrique contenue dans le circuit de refroidissement présente également une température comprise entre 0°C et 10°C.

Or, l'huile à basse température présente une forte viscosité, si bien qu'il est difficile de faire circuler cette huile dans le circuit. Il en résulte une perte de charge importante dans le premier échangeur, ainsi que dans les autres parties du circuit telle que des canalisations ou un second échangeur de chaleur, alors que le débit de la pompe reste sensiblement constant.

Dans ce cas, la pression à la sortie de la pompe augmente, ce qui génère des contraintes sur la pompe et sur un moteur entraînant cette pompe. De telles contraintes réduisent la durée de vie de la pompe, et impliquent généralement un surdimensionnement de la pompe, du moteur d'entraînement de la pompe, et du circuit électrique de distribution alimentant le moteur.

L'invention a notamment pour but de remédier à cet inconvénient, en fournissant un dispositif de conversion d'énergie dans lequel la pompe est protégée des problèmes de viscosité de l'huile à basse température.

A cet effet, l'invention a notamment pour objet un dispositif de conversion d'énergie, notamment pour un système d'entraînement électrique de station sous-marine de compression et de pompage, comportant un module de puissance, des moyens de refroidissement du module de puissance, et une enceinte étanche de logement du module de puissance et d'au moins une partie des moyens de refroidissement, les moyens de refroidissement comprenant :
- un circuit de refroidissement, dans lequel circule un fluide caloporteur,
- un premier échangeur de chaleur avec le module de puissance, à travers lequel passe le fluide caloporteur, et
- au moins une pompe d'entraînement du fluide caloporteur en circulation dans le circuit,
**caractérisé en ce que** le circuit de refroidissement comporte une branche de régulation de pression, s'étendant entre un premier embranchement relié à une sortie de la pompe d'entraînement, et un second embranchement relié à une entrée de cette pompe d'entraînement, la branche de régulation comprenant une vanne de régulation de pression, normalement fermée, propre à s'ouvrir lorsque la différence de pression entre la sortie et l'entrée de la pompe d'entraînement dépasse un seuil prédéterminé.

Lorsque la viscosité du fluide caloporteur, notamment lorsque ce fluide caloporteur est une huile diélectrique, est trop élevée, rendant difficile la circulation de ce fluide dans le circuit de refroidissement, notamment dans le premier échangeur, alors que le débit de la pompe reste sensiblement constant, la pression en sortie de pompe augmente.

La vanne de régulation de pression est alors ouverte, si bien qu'une partie du fluide est dérivée par la branche de régulation jusqu'à l'entrée de la pompe, réduisant ainsi la quantité de fluide circulant dans le circuit, et facilitant donc cette circulation en réduisant les contraintes sur le matériel.

Le fluide circulant dans le circuit, à travers le premier échangeur ou à travers la branche de régulation, est réchauffé, notamment sous l'effet des frottements entre ce fluide visqueux et les parois des conduits formant le circuit de refroidissement. Ainsi, la température du fluide augmente peu à peu jusqu'à ce que sa viscosité soit réduite en dessous d'un seuil prédéterminé de sorte que ce fluide peut circuler sans contrainte notable.

Un dispositif de conversion d'énergie selon l'invention peut comporter en outre l'une ou plusieurs des caractéristiques suivantes, prises seules ou selon toutes combinaisons techniquement possible :
- la vanne de régulation de pression comporte :
   - un corps de vanne dans lequel débouchent un conduit d'admission, relié au premier embranchement, et un conduit d'évacuation, relié au second embranchement,
   - un piston, mobile dans le corps de vanne entre une position d'obturation, dans laquelle le piston repose de manière étanche sur un siège de façon à obturer le conduit d'admission, et une position de dégagement, dans laquelle le piston est à distance du siège pour permettre une communication de fluide entre les conduits d'admission et d'évacuation, et
   - un organe élastique de rappel du piston vers sa position d'obturation ;
- le circuit de refroidissement comporte une vanne trois voies, comprenant :
   - une voie d'entrée, reliée à une branche de sortie du premier échangeur de chaleur,
   - une première voie de sortie, reliée à une branche d'entrée d'un second échangeur de chaleur, et
   - une seconde voie de sortie, reliée à une branche reliée à l'entrée de la pompe d'entraînement ;
- la vanne trois voies est commandée en fonction de la température du fluide caloporteur en un point déterminé, par exemple en entrée de cette vanne, et configurée pour relier la voie d'entrée à la première voie de sortie lorsque cette température du fluide caloporteur est supérieure à un seuil de température prédéterminé, et pour relier la voie d'entrée à la seconde voie de sortie lorsque cette température du fluide caloporteur est inférieure au seuil de température prédéterminé ;
- l'enceinte est au moins en partie emplie de gaz, de préférence de gaz neutre, par exemple l'azote ;
- l'enceinte est au moins en partie emplie d'un liquide caloporteur, tel que de l'huile diélectrique, le circuit de refroidissement étant, au moins en partie, immergé dans ce liquide caloporteur ;
- l'enceinte est entièrement emplie de fluide caloporteur et comporte un dispositif de limitation de pression, destiné à limiter la pression dans l'enceinte lorsque ce fluide caloporteur se dilate ; et
- le fluide caloporteur est un fluide diélectrique, de préférence une huile diélectrique.

L'invention concerne également un système d'entraînement électrique de station sous-marine de compression et de pompage, comportant un dispositif de conversion d'énergie tel que défini précédemment.

L'invention sera mieux comprise à la lecture de la description qui va suivre, donnée uniquement à titre d'exemple et faite en se référant aux figures annexées parmi lesquelles :
- la Figure 1 est une vue schématique d'un dispositif de conversion d'énergie selon un premier exemple de mode de réalisation de l'invention ;
- la Figure 2 est une vue schématique en coupe axiale d'une vanne de régulation de pression équipant le dispositif de la Figure 1 ;
- la Figure 3 est une vue similaire à la Figure 1 d'un dispositif de conversion d'énergie selon un deuxième exemple de mode de réalisation de l'invention.

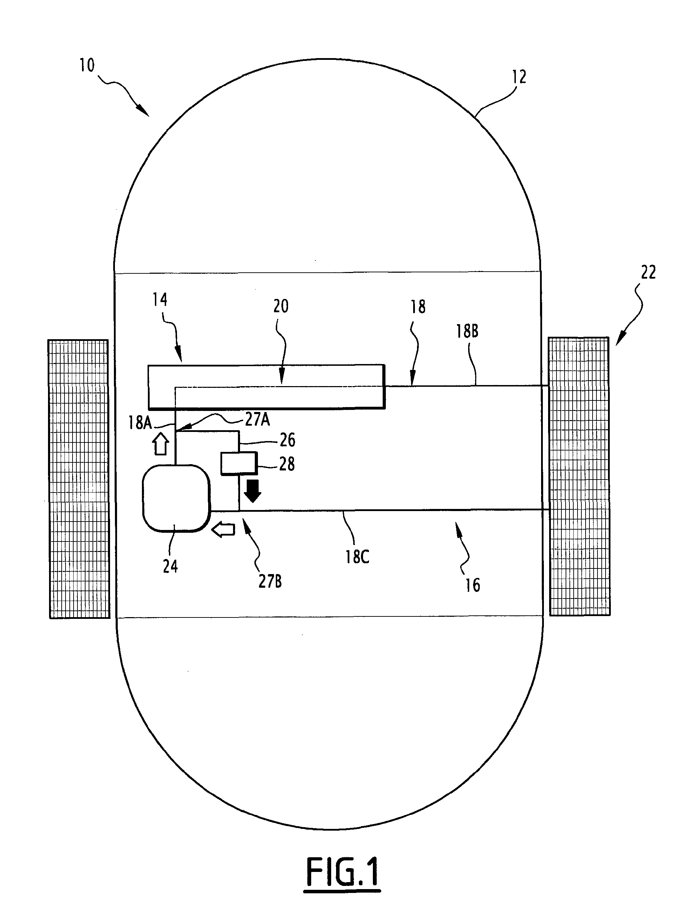

On a représenté, sur la Figure 1, un dispositif 10 de conversion d'énergie selon un premier exemple de mode de réalisation de l'invention.

Le dispositif de conversion d'énergie 10 est notamment destiné à équiper un système d'entraînement électrique de station sous-marine de compression et de pompage. Ainsi, ce dispositif de conversion d'énergie 10 est destiné à être agencé sur un fond marin, à une profondeur généralement comprise entre quelques mètres et plusieurs kilomètres.

Le dispositif de conversion d'énergie 10 comporte une enceinte étanche 12, dans laquelle sont logés un module de puissance 14 et au moins une partie de moyens 16 de refroidissement de ce module de puissance 14.

De manière connue en soi, le module de puissance 14 comporte des éléments d'électronique de puissance, et il est propre à assurer la fonction de conversion d'énergie.

Les moyens de refroidissement 16 comportent un circuit 18 de refroidissement, dans lequel circule un fluide caloporteur, avantageusement diélectrique.

De préférence, le fluide caloporteur est une huile diélectrique, telle que de l'huile silicone ou de l'huile commercialisée sous la référence MIDEL 7131 par Midel®.

Les moyens de refroidissement 16 comportent également un premier échangeur de chaleur 20 de type classique, destiné à échanger de la chaleur avec le module de puissance 14, à travers lequel passe le circuit de refroidissement 18. Le premier échangeur de chaleur 20 présente par exemple la forme d'une plaque creuse, contre laquelle sont agencés des éléments électroniques de puissance du module 14, et dans laquelle circule l'huile diélectrique. L'échangeur de chaleur peut également comporter des moyens d'échanges thermiques par circulation forcée à travers des composants du module de puissance 14, telles que des résistances et des éléments bobinés.

Les moyens de refroidissement 16 comportent également un second échangeur de chaleur extérieur 22 de type classique, agencé à l'extérieur de l'enceinte 12, de sorte que l'huile diélectrique circule dans ce second échangeur de chaleur 22 échange de la chaleur avec l'environnement du dispositif de conversion d'énergie 10, c'est-à-dire de l'eau de mer. On notera que l'eau de mer, notamment à grande profondeur, présente habituellement une température inférieure à 10°C, généralement environ égale à 4°C.

En variante, le second échangeur de chaleur 22 peut être agencé à l'intérieur de l'enceinte 12, en contact direct avec la paroi de cette enceinte 12, de façon à évacuer les calories vers l'eau de mer extérieure environnant cette enceinte 12.

Ainsi, l'huile diélectrique collecte des calories depuis le module de puissance 14 par l'intermédiaire du premier échangeur de chaleur 20, et délivre des calories à l'eau de mer par l'intermédiaire du second échangeur de chaleur 22.

Les moyens de refroidissement 16 comportent enfin au moins une pompe 24 d'entraînement de l'huile diélectrique en circulation dans le circuit 18. De préférence, les moyens de refroidissement 16 comportent au moins une pompe de secours, agencée en parallèle de la pompe 24 afin de former une redondance de pompes, susceptible de prendre le relais en cas de dysfonctionnement de la pompe 24.

Avantageusement, la pompe 24 est de type volumétrique.

Conformément au mode de réalisation décrit, l'enceinte 12 est emplie de gaz, de préférence de gaz neutre, par exemple l'azote.

Toutefois, en variante, l'enceinte 12 pourrait être emplie d'un liquide caloporteur, tel que de l'huile diélectrique, de façon que le circuit de refroidissement 18 soit, en partie ou en totalité, immergé dans ce liquide caloporteur. Dans le cas où l'enceinte 12 est entièrement remplie de liquide, le dispositif 10 comporte de préférence un dispositif de limitation de pression, destiné à limiter la pression dans l'enceinte 12 lorsque ce fluide se dilate, notamment sous l'effet de la température.

Le circuit 18 comporte au moins une première branche 18A s'étendant entre la pompe 24 et le premier échangeur 20, en sortie de la pompe 24, au moins une deuxième branche 18B s'étendant entre le premier échangeur 20 et le second échangeur 22, et au moins une troisième branche 18C s'étendant entre le second échangeur 22 et la pompe 24, en entrée de cette pompe 24.

Le circuit de refroidissement 18 comporte également une branche de régulation 26, s'étendant entre un premier embranchement 27A avec la première branche 18A, en sortie de la pompe d'entraînement 24, et un second embranchement 27B avec la troisième branche 18C, en entrée de la pompe d'entraînement 24. En d'autres termes, la branche de régulation 26 s'étend en parallèle de la pompe 24, entre la sortie et l'entrée de cette pompe 24.

La branche de régulation 26 comporte une vanne 28 de régulation de pression, normalement fermée, propre à s'ouvrir lorsque la différence de pression entre la sortie et l'entrée de la pompe d'entraînement 24 dépasse un seuil prédéterminé, par exemple 5 bars.

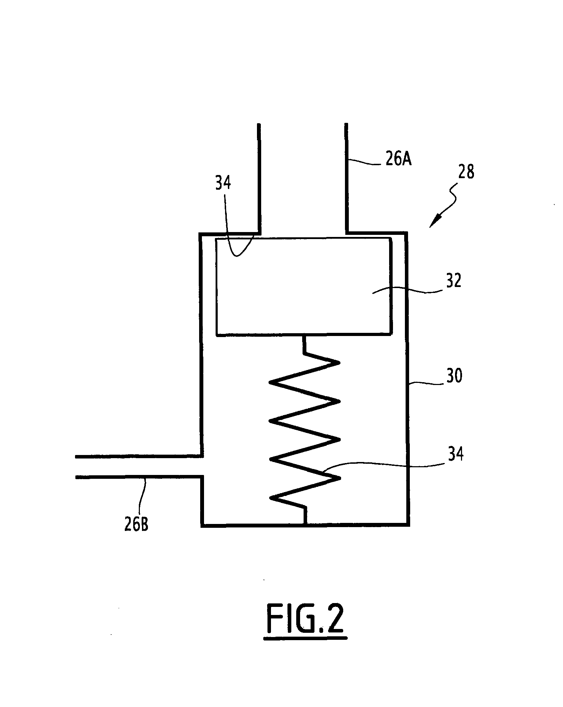

Un exemple de vanne de régulation 28 est représenté sur la Figure 2.

Cette vanne de régulation 28 comporte un corps de vanne 30, dans lequel débouche un conduit d'admission 26A, relié au premier embranchement 27A, et un conduit d'évacuation 26B relié au second embranchement 27B.

La vanne de régulation 28 comporte également un piston 32, mobile dans le corps de vanne 30 entre une position d'obturation, dans laquelle le piston 32 repose de manière étanche sur un siège 34 de façon à obturer le conduit d'admission 26A, et une position de dégagement, dans laquelle le piston est à distance du siège 34 pour permettre une communication entre les conduits d'admission 26A d'évacuation 26B. La vanne de régulation de pression comporte également un organe élastique 34 de rappel du piston 32 vers sa position d'obturation.

Ainsi, lorsque la pression en sortie de la pompe 24 augmente, cette pression induit un premier effort de pression sur une première surface du piston 32 qui est en regard du conduit d'admission 26A. Cet effort de pression s'oppose à la somme d'un effort élastique de rappel induit par l'organe élastique 34 et d'un second effort de pression opposé au premier, induit par la pression en entrée de la pompe 24 sur une seconde surface du piston 32 qui est tournée vers le conduit d'évacuation 26B.

La raideur de l'organe élastique 34 est choisie en fonction dudit seuil prédéterminé de différence de pression entre la sortie et l'entrée de la pompe, pour permettre l'ouverture de la vanne 28 lorsque cette différence de pression est supérieure à ce seuil prédéterminé.

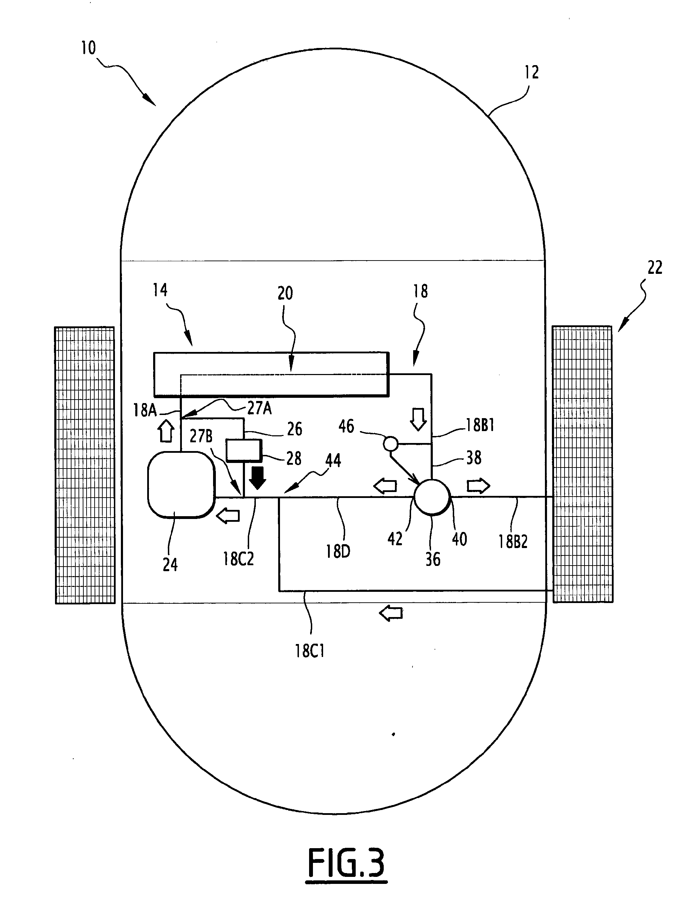

On a représenté sur la Figure 3 un dispositif de conversion d'énergie 10 selon un deuxième exemple de mode de réalisation de l'invention. Sur cette figure, les éléments analogues à ceux des figures précédentes sont désignés par des références identiques.

Conformément à ce deuxième mode de réalisation, le circuit de refroidissement 18 comporte une vanne trois voies 36, comprenant une voie d'entrée 38, reliée à une branche 18B1 de sortie de l'échangeur de chaleur 20, une première voie de sortie 40, reliée à une branche 18B2 d'entrée du second échangeur 22, et une seconde voie de sortie 42, reliée à une branche 18D s'étendant vers l'entrée de la pompe d'entraînement 24.

En effet, le circuit 18 comporte un embranchement 44 entre cette branche 18D, une branche 18C1 de sortie du second échangeur de chaleur 22, et une branche 18C2 d'entrée dans la pompe 24.

De préférence, la vanne trois voies 36 est commandée en fonction de la température de l'huile diélectrique en un point déterminé, notamment dans la branche 18B1 reliée à sa voie d'entrée 38. A cet effet, un capteur de température 46 est prévu pour mesurer la température sur cette branche 18B1. En variante, ce capteur de température 46 peut être intégré à la vanne trois voies 36, pour mesurer la température de l'huile à la voie d'entrée 38.

La vanne trois voies 36 est configurée pour relier la voie d'entrée 38 à la première voie de sortie 40 lorsque la température de l'huile diélectrique mesurée par le capteur 46 est supérieure à un seuil de température prédéterminé, et pour relier la voie d'entrée 38 à la seconde voie de sortie 42 lorsque cette température est inférieure à ce seuil.

Ainsi, lorsque la température de l'huile diélectrique est trop faible, par exemple inférieure à 30°C, sa viscosité est considérée comme trop élevée, si bien que cette huile diélectrique est redirigée vers la pompe 24, à travers la branche 18D, plutôt que d'être dirigée vers le second échangeur de chaleur 22, dans lequel l'huile perdrait des calories.

Toutefois, lorsque la température de l'huile correspond à une viscosité satisfaisante pour cette huile, la vanne 36 dirige l'huile vers le second échangeur de chaleur 22 pour un fonctionnement normal du circuit de refroidissement 18.

On décrira ci-dessous différents modes de fonctionnement du dispositif de conversion d'énergie 10 tel que décrit en référence à la Figure 3.

Un premier mode de fonctionnement de ce dispositif 10 est un mode de démarrage à froid. Ce mode de démarrage à froid est utilisé notamment après un arrêt prolongé du dispositif, lorsque la température de l'huile est proche de celle de l'eau de mer environnante. Dans ce cas, la viscosité de l'huile est élevée, si bien que lorsque la pompe 24 est mise en fonctionnement, la différence de pression entre la sortie et l'entrée de la pompe est relativement élevée.

Cette différence de pression élevée dépasse le seuil prédéterminé, si bien que la vanne 28 est ouverte. Une partie de l'huile passe donc par la branche de régulation 26, réduisant donc la quantité d'huile circulant dans le premier échangeur de chaleur 20.

L'huile passant par l'échangeur de chaleur 20 ressort par la branche 18B1, sa température restant faible, et inférieure au seuil prédéterminé de basculement de la vanne trois voies 36. Cette vanne 36 dirige donc l'huile vers la branche 18D, en direction de la pompe 24.

L'huile circule ainsi en s'échauffant peu à peu, notamment par frottement de l'huile visqueuse contre les parois des différents composants du circuit 18.

Cette élévation de température implique une baisse de la viscosité, si bien que la circulation de l'huile dans ce circuit est favorisée. La différence de pression entre la sortie et l'entrée de la pompe 24 se réduit alors peu à peu, jusqu'à ce que la vanne 28 soit entièrement fermée.

Lorsque l'huile atteint une température à laquelle sa viscosité est suffisante pour permettre un bon fonctionnement du premier échangeur de chaleur 20, on passe à un deuxième mode de fonctionnement, dans lequel le module de puissance 14 est mis en fonctionnement.

Dans ce mode de fonctionnement, la vanne 28 est fermée, et l'intégralité de l'huile passe par le premier échangeur de chaleur 20.

Lorsque le module de puissance 14 est en fonctionnement, la chaleur émise par ce module de puissance chauffe l'huile dans l'échangeur de chaleur 20, augmentant ainsi sa température. La température de l'huile augmente jusqu'à dépasser le seuil prédéterminé au-delà duquel la vanne trois voies 36 dirige l'huile en direction du second échangeur de chaleur 22.

On passe alors à un mode de fonctionnement normal du circuit de refroidissement 18.

On notera que l'invention n'est pas limitée au mode de réalisation précédemment décrit, mais pourrait présenter diverses variantes sans sortir du cadre des revendications.

En particulier, le circuit de refroidissement 18 peut comporter plusieurs branches de régulation de pression.

Par exemple, le circuit de refroidissement 18 peut comporter, en plus de la branche de régulation 26, une seconde branche de régulation s'étendant entre l'entrée et la sortie du premier échangeur 20, afin de limiter la différence de pression entre cette entrée et cette sortie, et ainsi limiter les contraintes dans ce premier échangeur 20.

Dans ce cas, cette seconde branche de régulation comporte une seconde vanne de régulation de pression, normalement fermée, propre à s'ouvrir lorsque la différence de pression entre la sortie et l'entrée du premier échangeur 20 dépasse un seuil prédéterminé, par exemple 3 bars.

On peut également envisager d'agencer une autre branche de régulation de pression entre l'entrée et la sortie du second échangeur 22.

Le fait de prévoir plusieurs branches de régulation de pression permet d'adapter le seuil prédéterminé d'ouverture de la vanne correspondante en fonction du type de matériel. Ainsi, on peut prévoir une première branche de régulation 26 pour la pompe 24, dont la vanne s'ouvre pour une différence de pression supérieure à 5 bars, et une seconde branche de régulation pour le premier échangeur 20, dont la vanne s'ouvre pour une différence de pression supérieure à 3 bars.

Conformément à une autre variante, toutes les branches de régulation de pression s'étendent à partir d'un point de référence en pression. Ce point de référence est par exemple formé par l'entrée de la pompe, du fait qu'il est connu que la pression en entrée de pompe 24 est au maximum égale à la pression statique du circuit 18, c'est-à-dire la pression 24 lorsque la pompe est au repos.

Ainsi, il est relativement simple de tarer la vanne de chaque branche de régulation, pour limiter la pression au point jusqu'auquel s'étend cette branche de régulation, en fonction de la pression connue du point de référence depuis lequel s'étant cette branche de régulation. On permet ainsi une maîtrise, en tout point souhaité du circuit, de la pression relative de ce point avec la pression du point de référence.

## Revendications

1. Dispositif (10) de conversion d'énergie, notamment pour un système d'entraînement électrique de station sous-marine de compression et de pompage, comportant un module de puissance (14), des moyens (16) de refroidissement du module de puissance (14), et une enceinte étanche (12) de logement du module de puissance (14) et d'au moins une partie des moyens de refroidissement (16), les moyens de refroidissement (16) comprenant :
- un circuit de refroidissement (18), dans lequel circule un fluide caloporteur,
- un premier échangeur (20) de chaleur avec le module de puissance (14), à travers lequel passe le fluide caloporteur, et
- au moins une pompe (24) d'entraînement du fluide caloporteur en circulation dans le circuit (18),
**caractérisé en ce que** le circuit de refroidissement (18) comporte une branche (26) de régulation de pression, s'étendant entre un premier embranchement (27A) relié à une sortie de la pompe d'entraînement (24), et un second embranchement (27B) relié à une entrée de cette pompe d'entraînement (24), la branche de régulation (26) comprenant une vanne (28) de régulation de pression, normalement fermée, propre à s'ouvrir lorsque la différence de pression entre la sortie et l'entrée de la pompe d'entraînement (24) dépasse un seuil prédéterminé.

2. Dispositif (10) de conversion d'énergie selon la revendication 1, dans lequel la vanne (28) de régulation de pression comporte :
- un corps de vanne (30) dans lequel débouchent un conduit d'admission (26A), relié au premier embranchement (27A), et un conduit d'évacuation (26B), relié au second embranchement (27B),
- un piston (32), mobile dans le corps de vanne (30) entre une position d'obturation, dans laquelle le piston (32) repose de manière étanche sur un siège (34) de façon à obturer le conduit d'admission (26A), et une position de dégagement, dans laquelle le piston (32) est à distance du siège (34) pour permettre une communication de fluide entre les conduits d'admission (26A) et d'évacuation (26B), et
- un organe élastique (34) de rappel du piston vers sa position d'obturation.

3. Dispositif (10) de conversion d'énergie selon la revendication 1 ou 2, dans lequel le circuit de refroidissement (18) comporte une vanne trois voies (36), comprenant :
- une voie d'entrée (38), reliée à une branche (18B1) de sortie du premier échangeur de chaleur (20),
- une première voie de sortie (40), reliée à une branche d'entrée (18B2) d'un second échangeur de chaleur (22), et
- une seconde voie de sortie (42), reliée à une branche (18D) reliée à l'entrée de la pompe d'entraînement (24).

4. Dispositif (10) de conversion d'énergie selon la revendication 3, dans lequel la vanne trois voies (36) est commandée en fonction de la température du fluide caloporteur en un point déterminé, par exemple en entrée de cette vanne (36), et configurée pour relier la voie d'entrée (38) à la première voie de sortie (40) lorsque cette température du fluide caloporteur est supérieure à un seuil de température prédéterminé, et pour relier la voie d'entrée (38) à la seconde voie de sortie (42) lorsque cette température du fluide caloporteur est inférieure au seuil de température prédéterminé.

5. Dispositif (10) de conversion d'énergie selon l'une quelconque des revendications précédentes, dans lequel l'enceinte (12) est au moins en partie emplie de gaz, de préférence de gaz neutre, par exemple l'azote.

6. Dispositif (10) de conversion d'énergie selon l'une quelconque des revendications précédentes, dans lequel l'enceinte (12) est au moins en partie emplie d'un liquide caloporteur, tel que de l'huile diélectrique, le circuit de refroidissement (18) étant, au moins en partie, immergé dans ce liquide caloporteur.

7. Dispositif (10) selon l'une quelconque des revendications précédentes, dans lequel l'enceinte (12) est entièrement emplie de fluide caloporteur et comporte un dispositif de limitation de pression, destiné à limiter la pression dans l'enceinte (12) lorsque ce fluide caloporteur se dilate.

8. Dispositif (10) selon l'une quelconque des revendications précédentes, dans lequel le fluide caloporteur est un fluide diélectrique, de préférence une huile diélectrique.

9. Système d'entraînement électrique de station sous-marine de compression et de pompage, comportant un dispositif (10) de conversion d'énergie selon l'une quelconque des revendications précédentes.

## Patentansprüche

1. Vorrichtung (10) zum Umwandeln von Energie, insbesondere für ein elektrisches Antriebssystem einer Unterwasserkompressions- und -pumpstation, die ein Leistungsmodul (14), Mittel (16) zum Kühlen des Leistungsmoduls (14) und ein dichtes Gehäuse (12) für die Aufnahme des Leistungsmoduls (14) und wenigstens eines Teils der Kühlungsmittel (16) umfasst, wobei die Kühlungsmittel (16) umfassen:
- einen Kühlungskreis (18), in dem ein Wärmeaustauschfluid zirkuliert,
- einen ersten Wärmetauscher (20) mit dem Leistungsmodul (14), durch den sich das Wärmeaustauschfluid bewegt, und
- wenigstens eine Pumpe (24) zum zirkulatorischen Antreiben des Wärmeaustauschfluids in dem Kreis (18), **dadurch gekennzeichnet, dass** der Kühlungskreis (18) einen Druckregulierungszweig (26) aufweist, der sich zwischen einer ersten Verzweigung (27A), die mit einem Ausgang der Antriebspumpe (24) verbunden ist, und einer zweiten Verzweigung (27B), die mit einem Eingang dieser Antriebspumpe (24) verbunden ist, erstreckt, wobei der Regulierungszweig (26) ein Druckregulierungsventil (28) aufweist, das normalerweise geschlossen ist und sich öffnen kann, wenn der Druckunterschied zwischen dem Ausgang und dem Eingang der Antriebspumpe (24) einen vorgegebenen Schwellenwert überschreitet.

2. Energieumwandlungsvorrichtung (10) nach Anspruch 1, wobei das Druckregulierungsventil (28) umfasst:
- einen Ventilkörper (30), in den eine Zulaufleitung (26A), die mit der ersten Verzweigung (27A) verbunden ist, und eine Entleerungsleitung (26B), die mit der zweiten Verzweigung (27B) verbunden ist, münden,
- einen Kolben (32), der in dem Ventilkörper (30) zwischen einer geschlossenen Stellung, in der der Kolben (32) dicht auf einem Sitz (34) aufliegt, derart, dass die Zulaufleitung (26A) geschlossen ist, und einer gelösten Stellung, in der sich der Kolben (32) in einem Abstand von dem Sitz (34) befindet, um eine Fluidkommunikation zwischen der Zulaufleitung (26A) von der Entleerungsleitung (26B) zu ermöglichen, beweglich ist, und
- ein elastisches Organ (34) zum Zurückstellen des Kolbens in seine geschlossene Stellung.

3. Energieumwandlungsvorrichtung (10) nach Anspruch 1 oder 2, wobei der Kühlungskreis (18) ein Dreiwegeventil (36) umfasst, das seinerseits umfasst:
- einen Eingangsweg (38), der mit einem Ausgangszweig (18B1) des ersten Wärmetauschers (20) verbunden ist,
- einen ersten Ausgangsweg (40), der mit einem Eingangszweig (18B2) eines zweiten Wärmetauschers (22) verbunden ist, und
- einen zweiten Ausgangsweg (42), der mit einem Zweig (18D), der mit dem Eingang der Antriebspumpe (24) verbunden ist, verbunden ist.

4. Energieumwandlungsvorrichtung (10) nach Anspruch 3, wobei das Dreiwegeventil (36) als Funktion der Temperatur des Wärmeaustauschfluids an einem bestimmten Punkt, beispielsweise am Eingang dieses Ventils (36), gesteuert wird und konfiguriert ist, um den Eingangsweg (38) mit dem ersten Ausgangsweg (40) zu verbinden, wenn diese Temperatur des Wärmeaustauschfluids höher als ein vorgegebener Temperaturschwellenwert ist, und um den Eingangsweg (38) mit dem zweiten Ausgangsweg (42) zu verbinden, wenn diese Temperatur des Wärmeaustauschfluids niedriger als der vorgegebene Temperaturschwellenwert ist.

5. Energieumwandlungsvorrichtung (10) nach einem der vorhergehenden Ansprüche, wobei das Gehäuse (12) wenigstens teilweise mit Gas, vorzugsweise Neutralgas, z. B. Stickstoff, gefüllt ist.

6. Energieumwandlungsvorrichtung (10) nach einem der vorhergehenden Ansprüche, wobei das Gehäuse (12) wenigstens zum Teil mit einer Wärmeaustauschflüssigkeit wie etwa einem dielektrischen Öl gefüllt ist, wobei der Kühlungskreis (18) wenigstens teilweise in diese Wärmeaustauschflüssigkeit eingetaucht ist.

7. Vorrichtung (10) nach einem der vorhergehenden Ansprüche, wobei das Gehäuse (12) vollständig mit dem Wärmeaustauschfluid gefüllt ist und eine Druckbegrenzungsvorrichtung umfasst, die dazu vorgesehen ist, den Druck in dem Gehäuse (12) zu begrenzen, wenn sich dieses Wärmeaustauschfluid ausdehnt.

8. Vorrichtung (10) nach einem der vorhergehenden Ansprüche, wobei das Wärmeaustauschfluid ein dielektrisches Fluid, vorzugsweise ein dielektrisches Öl, ist.

9. Elektrisches Antriebssystem für Unterwasserkompressions- und -pumpstation, das eine Energieumwandlungsvorrichtung (10) nach einem der vorhergehenden Ansprüche umfasst.

## Claims

1. Energy conversion device (10), in particular for an electric drive system of an underwater compression and pumping station, comprising a power module (14), means (16) for cooling the power module (14), and a sealed housing (12) for accommodating the power module (14) and at least part of the cooling means (16), the cooling means (16) comprising:
- a cooling circuit (18) in which a coolant fluid circulates,
- a first heat exchanger (20) with the power module (14), through which the coolant fluid passes, and
- at least one pump (24) for driving the coolant fluid in circulation within the circuit (18),
**characterised in that** the cooling circuit (18) comprises a pressure regulation branch (26) extending between a first branch (27A) linked to an outlet from the drive pump (24) and a second branch (27B) linked to an inlet of this drive pump (24), wherein the regulation branch (26) comprises a pressure regulation valve (28) which is normally closed and able to open when the pressure difference between the outlet and the inlet of the drive pump (24) exceeds a predetermined threshold.

2. Energy conversion device (10) according to claim 1, wherein the pressure regulation valve (28) comprises:
- a valve body (30) into which open an intake pipe (26A) which is linked to the first branch (27A), and an evacuation pipe (26B) which is linked to the second branch (27B),
- a piston (32) moveable in the valve body (30) between a sealing position in which the piston (32) rests in a sealed fashion on a seat (34) so as to seal the intake pipe (26A), and a release position in which the piston (32) is spaced from the seat (32) to allow fluid communication between the intake pipe (26A) and the outlet pipe (26B), and
- an elastic element (34) returning the piston to its sealing position.

3. Energy conversion device (10) according to claim 1 or 2, wherein the cooling circuit (18) comprises a three-way valve (36) comprising:
- an inlet path (38) linked to an outlet branch (18B1) of the first heat exchanger (20),
- a first outlet path (40) linked to an inlet branch (18B2) of a second heat exchanger (22), and
- a second outlet path (42) linked to a branch (18D) linked to the inlet of the drive pump (24).

4. Energy conversion device (10) according to claim 3, wherein the three-way valve (36) is controlled as a function of the temperature of the coolant fluid at a predetermined point, for example at the inlet to this valve (36), and configured to link the inlet path (38) to the first outlet path (40) when this coolant fluid temperature is higher than a predetermined temperature threshold, and to link the input path (38) to the second outlet path (42) when this coolant fluid temperature is lower than the predetermined temperature threshold.

5. Energy conversion device (10) according to any of the preceding claims, wherein the housing (12) is at least partly with gas, preferably an inert gas, for example nitrogen.

6. Energy conversion device (10) according to any of the preceding claims, wherein the housing (12) is at least partly filled with a coolant fluid such as dielectric fluid, the cooling circuit (18) being at least partly immersed in the coolant fluid.

7. Device (10) according to any of the preceding claims, wherein the housing (12) is completely filled with coolant fluid and comprises a pressure limitation device intended to limit the pressure in the housing (12) when this coolant fluid expands.

8. Device (10) according to any of the preceding claims, wherein the coolant fluid is a dielectric fluid, preferably a dielectric oil.

9. Electric drive system for an underwater compression and pumping station, comprising an energy conversion device (10) according to any of the preceding claims.
